**Europäisches Patentamt**

**European Patent Office**

**Office européen des brevets**

(19)

(11) **EP 1 189 284 A1**

(12) ## EUROPÄISCHE PATENTANMELDUNG

(43) Veröffentlichungstag:
**20.03.2002 Patentblatt 2002/12**

(51) Int Cl.[7]: **H01L 27/02**

(21) Anmeldenummer: **01000369.7**

(22) Anmeldetag: **15.08.2001**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **21.08.2000 DE 10041139**

(71) Anmelder:
- **Philips Corporate Intellectual Property GmbH
  52064 Aachen (DE)**
  Benannte Vertragsstaaten:
  **DE**
- **Koninklijke Philips Electronics N.V.
  5621 BA Eindhoven (NL)**
  Benannte Vertragsstaaten:
  **FR GB**

(72) Erfinder:
- **Schröder, Hans-Ulrich, Dr.
  52064, Aachen (DE)**
- **Reiner, Joachim Christian, Dr.
  52064, Aachen (DE)**

(74) Vertreter: **Volmer, Georg, Dipl.-Ing. et al
  Philips Corporate Intellectual Property GmbH,
  Habsburgerallee 11
  52064 Aachen (DE)**

(54) **Anordnung zur Verbesserung des ESD-Schutzes bei einem CMOS Buffer**

(57) Die Erfindung betrifft eine Anordnung zur Verbesserung des ESD-Schutzes bei einem CMOS Buffer mit mehreren PMOS Transistoren (52-62) und mehreren, mit den PMOS Transistoren in Serie geschalteten NMOS Transistoren (63), die um einer erhöhten Strombelastung im Falle einer elektrostatischen Entladung standhalten zu können, eine größere Fingerweite $W_N$ aufweisen, als die Fingerweite $W_P$ der PMOS Transistoren.

Fig.5

EP 1 189 284 A1

**Beschreibung**

Die Erfindung betrifft eine Anordnung zur Verbesserung des ESD-Schutzes bei einem CMOS Buffer mit mehreren parallel zueinander geschalteten PMOS Transistoren und mehreren parallel zueinander, mit den PMOS Transistoren in Serie geschalteten NMOS Transistoren.

Elektrostatische Entladungen (ESD) gehören zu den destruktivsten, unvermeidbaren Umwelteinflüssen, denen elektronische Systeme und integrierte Schaltungen ausgesetzt sind. So müssen integrierte Schaltungen bei einem ESD-Ereignis während Nanosekunden Ströme im Amperebereich leiten. Der zerstörende Einfluss dieser Stromdichten auf die Schaltung liegt einerseits in der sehr hohen thermischen Verlustleistung bezogen auf die Größe des Schaltungselements, andererseits werden Überspannungen auf dem Chip erzeugt, welche dünne Oxide zerstören können. Aus der Sicht der Schaltungsentwicklung in modernen VLSI-Prozessen wird die Beherrschung dieser parasitären Effekte zum zentralen Problem, da die Miniaturisierung die Empfindlichkeit gegenüber ESD-Ereignissen erhöht.

Elektrostatische Ladungen entstehen durch Reibung zwischen Materialien, wie es das Gehen auf Teppichen verursachen kann. Durch Kumulation und Speicherung der Ladung können elektrostatische Potentiale von mehreren kV entstehen. Bei der Berührung von hochintegrierten Halbleiterbauelementen fließen diese gespeicherten Ladungen ab, was auch als elektrostatische Entladung (ESD) bezeichnet wird. Aus elektrischer Sicht stellen elektrostatische Entladungen transiente Hochstromereignisse von mehreren Ampere Spitzenstrom dar, mit einer Dauer von 10 ns bis 300 ns. Diese transienten Ströme gefährden integrierte Schaltungen auf unterschiedliche Arten:

- einerseits können die elektrischen Überlastungen die integrierte Schaltung thermisch zerstören.
- andererseits kann eine Überspannung bei den MOS-Gates Gateoxiddurchbrüche verursachen.
- außerdem können durch mehrfache ESD-Belastungen Degradationserscheinungen auftreten, die eine Erhöhung der Leckströme nach sich ziehen.

Unabhängig von der Art der ESD-Belastung erfährt das Halbleiterbauelement entweder einen irreparablen Schaden oder es wird eine unzureichende oder schlechter werdende Funktionsweise erzeugt.

Mit zunehmender Integrationsdichte von CMOS Prozessen nimmt die Gefahr von Ausfällen integrierter Schaltungen zu, die auf Zerstörung durch elektrostatische Entladungen zurückzuführen sind.

Mittels bekannter ESD Schutzschaltungen wird eine Spannungsbegrenzung vorgenommen. Die eigentliche zu schützende Schaltung muss eine dazu passende Überspannungsfestigkeit aufweisen.

In der US 6 034 552 wird eine ESD-Schutzschaltung beschrieben, die eine dynamische Floatinggateanordnung benutzt. Mittels dieser Anordnung wird die ESD Robustheit der stromtreibenden programmierbaren CMOS Ausgangsbuffer verbessert. Diese ESD-Schutzschaltung beansprucht zusätzliche Fläche auf dem Silizium und ist für interne Buffer aufwendig in den Prozess zu integrieren.

Aufgabe der Erfindung ist es deshalb, eine Anordnung bereitzustellen, die die Überspannungsfestigkeit von Schaltungen erhöht.

Diese Aufgabe wird dadurch gelöst, dass die einzelnen Transistoren durch Fingerflächen realisiert sind und die Fingerweite $W_N$ der Gates der NMOS Transistoren derart ausgestaltet ist, einen Strom im ESD-Fall ohne Zerstörung des Transistorsfingers zu leiten.

Die Fehler, die durch ESD-Belastung auf CMOS Schaltungsanordnungen entstehen können, werden hauptsächlich durch das Snap-Back-Phänomen der NMOS Transistoren verursacht. Ganz besonders sind große Buffer davon betroffen, wie sie bspw. für Taktgeneratoren benutzt werden oder prinzipiell Buffer, die eine sehr hohe Ausgangstreiberleistung zur Verfügung stellen müssen. Die Buffersensitivität bezüglich der ESD Robustheit, ist dabei ein Problem, welches sehr vom Layout abhängig ist.

Gerade NMOS Transistoren zeigen ein Snap-Back-Verhalten der Drain Source Spannung $V_{DS}$, wenn die Drain Source Spannung $V_{DS}$ eine Triggerspannung erreicht, die über der Drain Substrat Durchbruchspannung $V_{BD}$ liegt.

Dieses Snap-Back-Verhalten der Drain Source Spannung $V_{DS}$ tritt wegen des positiven Feedbackmechanismus zwischen dem Avalanchebreakdown des Drain Substrat Überganges und des parasitären Bipolartransistors, der durch Drain, Bulk und Source gebildet wird, auf. Wenn dieser Avalanchefeedbackmechanismus einmal lokal begonnen hat, breitet er sich entlang des Drainrandes durch laterale Diffusion der betroffenen Ladungsträger aus, bis der ganze Transistorfinger homogen im Snap-Back-Mode operiert. In diesem Snap-Back-Mode ist der differentielle Widerstand des betroffenen NMOS Transistors sehr gering. Dadurch wird der Stromfluss durch externe Widerstände nicht ausreichend begrenzt, was zur Zerstörung des NMOS Transistors führen kann. Bei PMOS Transistoren tritt dieses signifikante Snap-Back-Phänomen nicht oder nur in sehr geringer Ausprägung auf, daher sind diese PMOS Transistoren robuster bezüglich ESD-Belastungen.

Während einer ESD-Belastung steigt die an der Schaltung anliegende Spannung über die normale Versorgungsspannung $V_{DD}$. Mit einer typischen ESD on Chip Schutzschaltung, wird die $V_{DD}$-$V_{SS}$ Spannung begrenzt auf ein Level $V_{DDclamp}$. Diese Spannung $V_{DDclamp}$ liegt dann an dem gesamten aktiven Schaltkreis im Falle einer ESD -Belastung an. Abhängig von dem Spannungslevel an den Gates des Buffers fließt ein Strom durch den Buffer von $V_{DD}$ zu $V_{SS}$ durch die PMOS und NMOS Transistoren. Dabei können drei unterschiedliche Fälle unterschieden werden.

1. Der PMOS Transistor ist nichtleitend und der NMOS Transistor leitend.
Dabei liegt die Spannung $V_{DDclamp}$ am PMOS Transistor an. Der PMOS Transistor ist meist robust genug, um nicht zerstört zu werden.

2. beide Transistoren, sowohl der PMOS als auch der NMOS Transistor, sind leitend. Dabei fließt ein Strom, der durch den Widerstand der zwei Transistoren in Reihe begrenzt wird. Wenn die Transistorgröße der PMOS und NMOS Transistoren nicht stark unterschiedlich ist, was normalerweise nicht der Fall ist, ist die Stromdichte, die auftreten kann, weit genug unter einer Fehlerschwellspannung für die meisten Technologien.

3. der PMOS Transistor ist leitend und der NMOS Transistor ist nichtleitend.
In diesem Fall liegt die Spannung $V_{DDclamp}$ am NMOS Transistor über den leitenden PMOS Transistor an. Wenn dann die $V_{DS}$-Spannung des NMOS Transistors die Snap-Back-Triggerspannung $V_{Trigg}$ erreicht, geht dieser NMOS Transistor in den Snap-Back-Mode. Wegen des niedrigen differentiellen Widerstandes des NMOS Transistors im Snap-Back-Mode wird der Strom hauptsächlich durch den Widerstand des PMOS Transistors begrenzt. Für typische Inverter ist die resultierende Stromdichte niedriger als ein sprechender Fehlerlevel.

In großen Buffern sind die Transistoren üblicherweise als Multifingerdevices ausgebildet. Ein Buffer stellt beispielsweise eine Inverterstufe zur Impedanzwandlung dar, bei der ein gegebenes Signal mit großer Ausgangsleistung getrieben werden soll. Es handelt sich um eine Art Verstärkerstufe oder Treiberstufe. Daher werden auch große Transistoren mit vielen Fingern verwendet, was zu den beschriebenen Problemen führen kann. Durch eine Erhöhung der Fingerzahl lässt sich dabei die Treiberleistung des Buffers erhöhen.

Als interne Buffer werden Buffer bezeichnet, die interne Knoten einer CMOS Schaltung treiben, jedoch keine außerhalb der Schaltung liegenden Ein- oder Ausgangspads. Bei internen Buffern kann eine ESD-Entladung nicht über Ein- oder Ausgangspads in den Buffer gelangen. Im Unterschied dazu treibt ein Ausgangsbuffer Ein- oder Ausgangspads. Über diese Ein- oder Ausgangspads kann die ESD-Entladung direkt den Ausgangsbuffer treffen.

Wenn die $V_{Trigg}$ der NMOS Transistoren in einem derartigen Multifingerschaltkreis erreicht wird, kann es auftreten, dass der Finger, der gerade geschaltet wird, als erstes die Drain Source Spannung der anderen NMOS Transistoren, die parallel geschaltet sind, herunterzieht. Dadurch können die anderen Finger nicht mehr schalten und der geschaltete NMOS Transistor zieht den gesamten Strom, der normalerweise über alle Finger fließt, auf sich. In diesem Fall überschreitet die Stromdichte für einen einzelnen geschalteten NMOS Finger schnell einen Schwellwert, was zur Zerstörung dieses Fingers und letztlich des Schaltkreises führt. Der zerstörte Finger bleibt dann offen, was sich in einem erhöhten Betriebs- und Stand-By-Strom niederschlägt. Aus den oben beschriebenen Gründen ist das Auftreten von Fehlern in diesen Buffern abhängig von der Eingangspannung während einer ESD-Belastung.

Die NMOS Transistorfinger werden aufgrund der zu hohen Stromdichte während eines ESD Ereignisses beschädigt. Der Fehlerstromlevel beträgt typischerweise einige Milliampere pro μm Transistorfingerweite, wobei diese stark davon abhängt, welche CMOS-Herstellungstechnologie verwendet wird und außerdem von der Kanallänge beeinflusst wird. Der kritische Layoutparameter lässt sich mit dem Verhältnis der gesamten PMOS Transistorweite und der Einzel-NMOS-Transistorfingerweite beschreiben. Es wird häufig auch als Fingerweitenverhältnis $R_W$ bezeichnet.

$$R_W = W_P^{single} \times N_P / W_N^{single} \qquad (1)$$

mit

$W_P^{single}$ als Einzelfingerweite eines PMOS Transistors

$W_N^{single}$ als Einzelfingerweite eines NMOS Transistors

$N_P$ Anzahl der PMOS Transistoren

Für ein traditionelles Layout ist das Fingerweitenverhältnis $R_W$ groß. Buffer sind traditionell mit entsprechenden PMOS Transistoren und NMOS-Transistorenfingerweiten derart ausgebildet, dass der Buffer in ein gegebenes Power-Supply-Rail-Gitter passt. Die Treiberleistung des Buffers, die in diesem Sinne realisiert werden kann, ohne ein kritisches Fingerweitenverhältnis $R_{WC}$ zu überschreiten, ist begrenzt. Größere und stärkere Buffer mit einem Verhältnis $R_W < R_{WC}$ können durch eine Erhöhung der Fingerweite des Transistors realisiert werden. Derartige Buffer würden dann jedoch nicht in das Power-Supply-Gitter passen, welches zu Schwierigkeiten bei der Erstellung des Schaltkreises führen kann. Eine weitere Möglichkeit um einen derartigen Buffer robuster gegen ESD Ereignisse zu machen, wäre einen Widerstand in Reihe zu jedem NMOS-Transistorfinger zu schalten. Dies erfordert jedoch zusätzlichen Platz auf dem Silizium und reduziert gleichzeitig die Ausgangstreiberleistung des Buffers.

Deshalb wird erfindungsgemäß vorgeschlagen, die Weite der NMOS Finger derart zu gestalten, dass eine erhöhte Stromdicht im ESD- Fall nicht zur Zerstörung des Transistorfingers führt. Dazu kann vorteilhafterweise die Weite der NMOS-Finger derart vergrößert werden, dass im Falle einer ESD-Belastung der geschaltete NMOS Transistor-Finger nicht zerstört wird, indem aufgrund seiner großen Weite der Gesamtstrom, den die PMOS-Transistorfinger liefern, nicht zu einer kritischen Stromdichte im geschalteten NMOS Finger führt. Bei einem Verhältnis $R_w$, bei dem der Summe der Fingerweiten der PMOS Transistoren zu der Fingerweite jedes Einzel-NMOS Transistors kleiner als 5 ist, kann man davon ausgehen, dass der geschaltete NMOS Transitorfinger im ESD-Fall die Stromdichte nicht zur Zerstörung des Transitors führt.

In einer weiteren Ausführungsform der Erfindung sind die Transistorfinger der NMOS Transistoren derart ausgebildet, dass eine Stromdichte im ESD-Fall von 5mA/μm nicht überschritten wird Durch Vergrößerung der Weite der Transistorfinger kann einer erhöhten Stromdicht vorgebeugt werden.

In einer bevorzugten Ausführungsform der Erfindung weisen die Gates der NMOS Transistoren eine Fingerweite $W_N$ auf, die mindestens 10 mal größer als die Länge $L_N$ der Gates der Transistorfinger der NMOS Transistoren ist. Besonders bei CMOS Buffern, die eine große Ausgangsleistung aufweisen müssen, ist diesen Längen-Weiten Verhältnis charakteristisch.

Eine besondere Ausführungsform der Erfindung wird dadurch erreicht, dass zu den PMOS Transistoren eine geringere Anzahl von parallel geschalteten NMOS Transistoren in Serie geschaltet wird. Diese parallel geschalteten NMOS Transistoren weisen an den Gates eine größere Fingerweite auf, als die Fingerweite der Gates der PMOS Transistoren, wodurch im ESD Fall die im NMOS Finger auftretende Stromdichte reduziert wird.

In einer weiteren Ausführungsform der Erfindung werden die PMOS Transistoren und die NMOS Transistoren mittels eines Multigates verbunden. Vorzugsweise können auch Gruppen von PMOS- und/oder NMOS Transistoren mittels eines Multigates miteinander verbunden werden. Ebenso ist es denkbar, dass jeder einzelne Transistor an seinem Gate ein unabhängiges Signal erhält.

In einer weiteren erfindungsgemäße Ausführungsform sind PMOS Transistoren in einer Logikschaltung miteinander verknüpft, zu denen ein oder höchsten genauso viele NMOS Transistoren mit größerer Gatefingerweite in Serie geschaltet sind. Ebenso kann die Parallelschaltung der NMOS Transistoren Serienschaltungen mehrerer NMOS Transistoren enthalten.

Die Aufgabe wird auch mit einer Verstärkerschaltung gelöst, bei der ein CMOS Buffer nach den Ansprüchen 1 bis 9 als Ausgangsstufe fungiert.

Nachfolgend wird anhand der Zeichnungen ein Ausführungsbeispiel näher beschrieben. Es zeigen:

Fig. 1    Prinzip des Snap-Back-Modes.

Fig. 2    ESD-Schutznetzwerk mit ESD-Belastung zwischen den Ein- und Ausgängen

Fig. 3    Schaltung für einen Buffer nach dem Stand der Technik

Fig. 4    Layout für Buffer

Fig 5    erfindungsgemäßes Layout eines Buffers

Fig. 6a, b    Schaltung mit mehreren PMOS und NMOS Transistoren in Serie

Fig. 7    Schaltung für einen Ausgangstreber

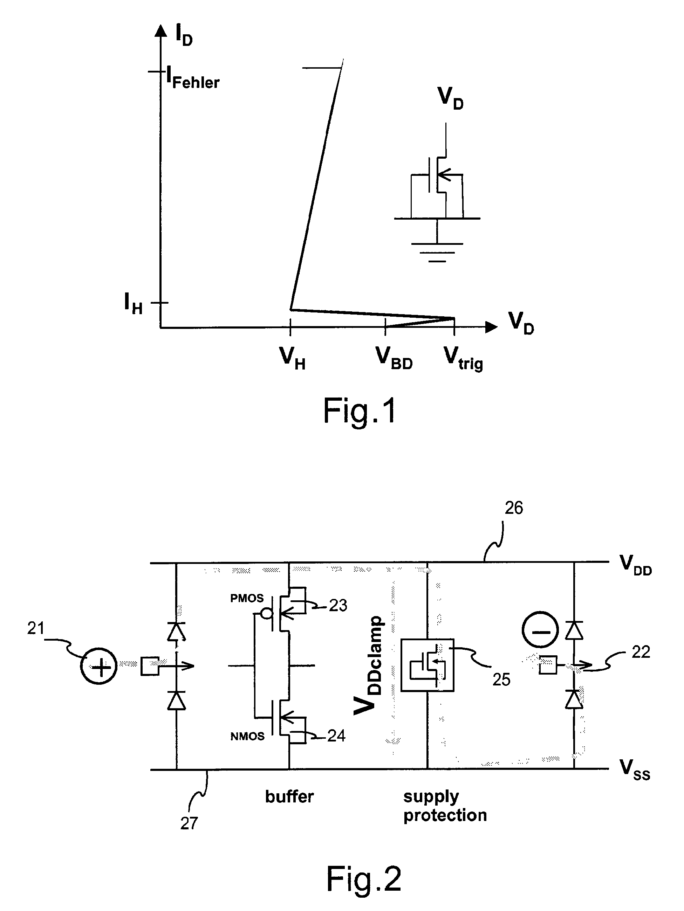

In Fig. 1 wird der Stromverlauf des Drain Source Stroms eines NMOS Transistors mit geerdetem Gate über der Drain-Spannung $V_D$ dargestellt. Wenn die Drain-Spannung die Spannung $V_{BD}$ übersteigt, fließt ein Rückwärtsdurchbruchstrom des Drain Source Übergangs. In dem Moment wenn die Drain-Spannung $V_D$ die Schaltspannung $V_{trig}$ erreicht, schnappt die Drain-Spannung auf den Wert $V_H$ zurück. Wenn der Drain-Strom $I_D$ größer als der Strom $I_H$ wird, steigt der Drain-Strom wieder an, wobei der Anstieg der Drainspannung jedoch gering bleibt. Erreicht der Drain- Strom der Wert $I_F$, tritt die Beschädigung des Transistors ein.

In Fig. 2 ist eine Prinzipschaltung eines ESD-Schutznetzwerkes mit einem internen Buffer dargestellt, mit folgenden Bestandteilen Eingang 21, Ausgang 22, PMOS Transistor 23, NMOS Transistor 24. Die ESD-Schutzschaltung 25 ist zwischen $V_{DD}$ 26 und $V_{SS}$ 27 geschaltet. Im dargestellten ESD-Fall fließt ein Strom über $V_{DD}$ durch das Schutznetzwerk 25 zum Ausgang 22. Dabei liegt dann zwischen $V_{DD}$ 26 und $V_{SS}$ 27 die Spannung $V_{DDClamp}$ an. Je nachdem ob die Transistoren 23 und 24 leitend oder nichtleitend sind, fließt auch über diese Transistoren ein Strom und führt entsprechend den zuvor beschriebenen Zuständen zu einer Zerstörung oder nicht.

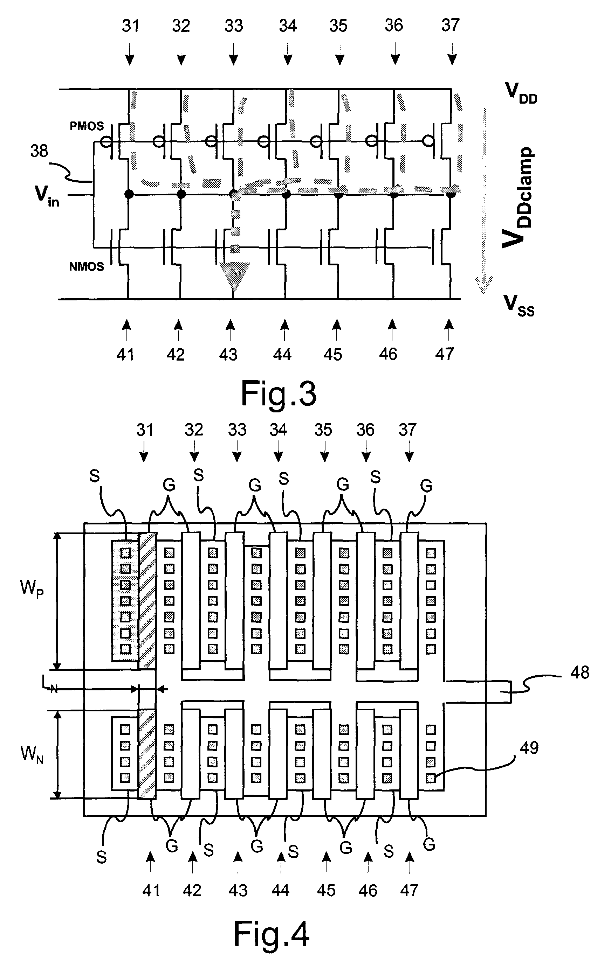

In Fig. 3 ist ein Buffer gemäß dem Stand der Technik dargestellt. Dabei sind mehrere PMOS Transistoren 31 bis 35 dargestellt, die parallel zueinander geschaltet sind Die NMOS Transistoren 41 bis 45 sind ebenfalls parallel zueinander geschaltet. Über ein Multigate 38 sind diese Transistoren miteinander verbunden. Dieses Multigate 38 ist der Eingang der Schaltung In einem ESD-Fall würde ein Strom über alle PMOS Transistoren fließen, jedoch nur über den gerade geschalteten, im Snap-back Mode befindlichen NMOS Transistor, hier 43. Dadurch, dass sich der Strom auf alle PMOS Transistoren verteilt, gleichzeitig aber über nur einen NMOS Transistor abgeführt wird, kann eine Zerstörung dieses NMOS Transistors auftreten.

In Fig. 4 ist das Layout eines Buffer gemäß dem Stand der Technik und der in Fig. 3 erklärten Prinzipschaltung dargestellt. Mit S sind jeweils die Sources der Transistoren bezeichnet. Im Bild oben liegend sind die PMOS Transistoren 31 bis 37 dargestellt. Im Bild unten liegend sind die NMOS Transistoren 41 bis 47 dargestellt. Die Transistoren sind über eine gemeinsame Drain 48 miteinander verbunden. In diesem Layout sind die Gates der PMOS- und NMOS Transistoren als unabhängige Gatefinger realisiert und nicht als Multigates wie in Figur 3. Der Strom fließt in den Transistoren von Drain zur Source über das Gate, so dass in dieser Darstellung die Gatelänge L deutlich geringer ist, als die Fingerweite W der Gates In dieser Darstellung ist außerdem die Fingerweite $W_N$ der NMOS-Transistorfingergates geringer, als die Fingerweite $W_P$ der PMOS-Transistorfingergates. Mit 49 sind die Kontakte bezeichnet.

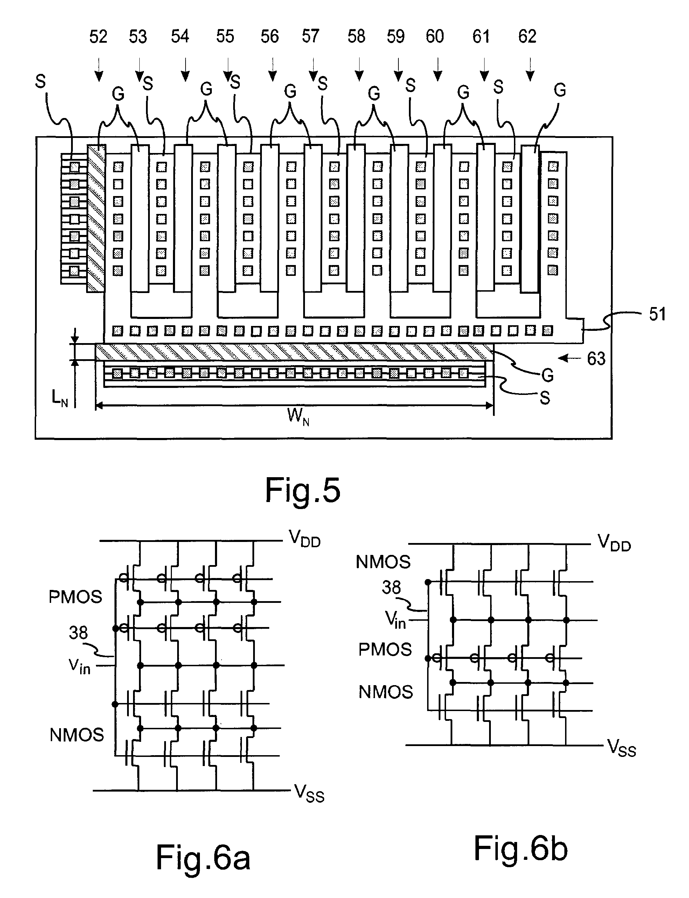

In Fig. 5 ist eine erfindungsgemäße Darstellung des Layouts dargestellt. Hier sind die PMOS Transistoren 52 -62 parallel zueinander geschaltet und über eine gemeinsame Drain 51 miteinander verbunden. Zu den PMOS Transistoren 52 bis 62 ist nur ein NMOS Transistor 63 in Serie geschaltet. Dieser NMOS Transistor 63 weist eine deutlich größere Weite der Gatefingers $W_N$ auf, als die PMOS Transistoren 52 bis 62. Aufgrund dieser erhöhten Fingerweite $W_N$ ist in einer derartigen Anordnung der NMOS Transistor 63 gegen eine Beschädigung durch erhöhten Stromfluss im Falle einer ESD-Belastung geschützt und kann den auf die mehreren PMOS Transistoren verteilten Strom ungefährdet abführen.

Die Figuren 6a und 6b zeigen interne CMOS Buffer, bei denen Kombinationen von Parallel und Serienschaltungen von NMOS und PMOS Transistoren verwendet werden. Die Transistoren sind jeweils mit einem Multigate 38 miteinander verbunden. Bei einer Serienschaltung von NMOS Transistoren weisen die in Serie geschalteten NMOS Transistoren Transistorfinger mit einer größeren Fingerweite auf, als die Fingerweite der Transistorfinger der PMOS Transistoren und können deshalb den Strom im ESD-Fall abführen.

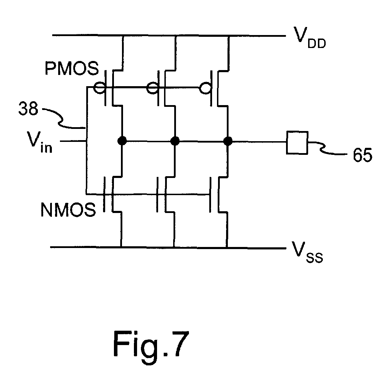

In Figur 7 ist ein Buffer als Ausgangstreiberstufe dargestellt. Dabei wird mittels des Buffers ein Ausgangspad 65 getrieben. Dieses Ausgangspad 65 ist außenliegend, so dass im ESD-Fall der ESD Entladungsstrom über dieses Ausgangspad 65 in den Buffer gelangen kann. Um den erhöhten Entladungsstrom abzuführen, wird der NMOS-Transistorfinger mit einer sehr großen Fingerweite ausgelegt.

Hierbei ist dann folgende Formel auf die Fingerweite des NMOS Transistors anzuwenden.

$$W_N^{single} * J_{krit} > I_{ESD}$$

$W_N^{single}$ als Einzelfingerweite eines NMOS Transistors

$J_{krit}$ die kritische Stromdichte ist (in mA/μm)

$I_{ESD}$ Strom im ESD-Fall

**Patentansprüche**

1. Anordnung zur Verbesserung des ESD-Schutzes bei einem CMOS-Buffer mit mehreren PMOS-Transistoren (31- 37) und mehreren, mit den PMOS Transistoren in Serie geschalteten NMOS Transistoren (41-47), bei dem die Gates (G) der einzelnen Transistoren durch Fingerflächen realisiert sind und die Fingerweite $W_N$ der Gates der NMOS Transistoren (41-47) derart ausgestaltet ist, einen Strom im ESD-Fall ohne Zerstörung des Transistorsfingers zu leiten.

2. Anordnung nach Anspruch 1
   **dadurch gekennzeichnet,**
   **dass** das Verhältnis der Summe der Fingerweiten der PMOS Transistoren zu der Fingerweite jedes Einzel-NMOS Transistors größer als 5 ist.

3. Anordnung nach Anspruch 1
   **dadurch gekennzeichnet,**
   **dass** die Transistorfinger der NMOS Transistoren derart ausgebildet sind, dass eine Stromdichte im ESD-Fall von 5mA/μm nicht überschritten wird.

4. Anordnung nach Anspruch 1
   **dadurch gekennzeichnet,**
   **dass** die Fingerweite $W_N$ der Gates der NMOS Transistoren (41-47) größer als die Fingerweite $W_P$ der Gates der PMOS Transistoren ist.

5. Anordnung nach Anspruch 1
   **dadurch gekennzeichnet,**
   **dass** die Gates der NMOS Transistoren eine Fingerweite $W_N$ aufweisen, die mindestens 10 mal größer als die Länge $L_N$ der Transistorfinger der Gates der NMOS Transistoren ist.

6. Anordnung nach Anspruch 1,
   **dadurch gekennzeichnet,**
   **dass** zu den PMOS Transistoren (52-62) höchstens genauso viele parallel geschaltete NMOS Transistoren (58) in Serie geschaltet sind.

7. Anordnung nach Anspruch 1,
   **dadurch gekennzeichnet,**
   **dass** die PMOS Transistoren mit den NMOS Transistoren mittels eines Multigates (38) verbunden sind.

8. Anordnung nach Anspruch 1,
   **dadurch gekennzeichnet,**
   **dass** Gruppen von Transistoren mittels eines Multigates miteinander verbunden sind.

9. Anordnung nach Anspruch 1,
   **dadurch gekennzeichnet,**
   **dass** die Anordnung der PMOS Transistoren Serienschaltungen mehrerer PMOS Transistoren enthält.

10. Anordnung nach Anspruch 1,

**dadurch gekennzeichnet,**
**dass** eine Parallelschaltung der NMOS Transistoren Serienschaltungen mehrerer NMOS Transistoren enthält.

11. Anordnung nach Anspruch 1,
**dadurch gekennzeichnet,**
**dass** der Buffer eine Kombination aus Parallel- und Serienschaltungen von NMOS und PMOS Transistoren enthält.

12. Anordnung nach Anspruch 1,
**dadurch gekennzeichnet,**
**dass** der Buffer eine Ausgangsstufe einer CMOS Schaltung darstellt und die Fingerweite eines NMOS Transistors, so groß ist, einen am Ausgangspad (65) auftretenden ESD-Entladungsstrom abzuführen.

13. Verstärkerschaltung mit einem CMOS Buffer nach einem der Ansprüche 1 bis 12 als Ausgangsstufe.

Fig.1

Fig.2

Fig.3

Fig.4

52  53  54  55  56  57  58  59  60  61  62

## Fig.5

## Fig.6a

## Fig.6b

Fig.7

**Europäisches Patentamt**

**EUROPÄISCHER RECHERCHENBERICHT**

Nummer der Anmeldung

EP 01 00 0369

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | US 5 060 037 A (ROUNTREE ROBERT N) 22. Oktober 1991 (1991-10-22) | 1-4,6-8, 11-13 | H01L27/02 |
| Y | * Spalte 9, Zeile 56 – Spalte 10, Zeile 17; Abbildungen 2,7 * | 9,10 | |
| X | * Ansprüche 7,8,10 * | 5 | |
| Y | US 5 780 897 A (KRAKAUER DAVID BENJAMIN) 14. Juli 1998 (1998-07-14) * Spalte 4, Zeile 57 – Zeile 67; Abbildungen 2-4 * * Spalte 5, Zeile 14 – Zeile 28 * * Spalte 6, Zeile 66 – Spalte 7, Zeile 7; Abbildung 7 * | 9,10 | |
| X | US 5 898 206 A (YAMAMOTO YUHIDE) 27. April 1999 (1999-04-27) * Zusammenfassung; Abbildung 1 * * Spalte 7, Zeile 57 – Spalte 9, Zeile 24 * | 1,6-8,11 | |
| X | US 4 808 861 A (EHNI GEORGE J) 28. Februar 1989 (1989-02-28) * Abbildung 1 * | 1,2,4,5, 11-13 | RECHERCHIERTE SACHGEBIETE (Int.Cl.7) H01L |

Der vorliegende Recherchenbericht wurde für alle Patentansprüche erstellt

| Recherchenort | Abschlußdatum der Recherche | Prüfer |
|---|---|---|
| MÜNCHEN | 11. September 2001 | Agne, M |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

EP 1 189 284 A1

**ANHANG ZUM EUROPÄISCHEN RECHERCHENBERICHT**
**ÜBER DIE EUROPÄISCHE PATENTANMELDUNG NR.** EP 01 00 0369

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

11-09-2001

| Im Recherchenbericht angeführtes Patentdokument | | Datum der Veröffentlichung | Mitglied(er) der Patentfamilie | | Datum der Veröffentlichung |
|---|---|---|---|---|---|
| US 5060037 | A | 22-10-1991 | JP<br>JP | 1020651 A<br>2792628 B | 24-01-1989<br>03-09-1998 |
| US 5780897 | A | 14-07-1998 | US<br>US | 5932918 A<br>6097071 A | 03-08-1999<br>01-08-2000 |
| US 5898206 | A | 27-04-1999 | JP<br>JP<br>CN | 3144330 B<br>10189756 A<br>1186341 A | 12-03-2001<br>21-07-1998<br>01-07-1998 |
| US 4808861 | A | 28-02-1989 | KEINE | | |

EPO FORM P0461

Für nähere Einzelheiten zu diesem Anhang : siehe Amtsblatt des Europäischen Patentamts, Nr.12/82